# EUROPEAN PATENT SPECIFICATION

(11) **EP 2 099 612 B1**
(45) Date of publication and mention of the grant of the patent: **06.06.2012**
(21) Application number: 07865885.3
(22) Date of filing: 19.12.2007
(51) Int. Cl.: B41J 2/01, H05K 3/12

(54) **PRINTING SYSTEM WITH CONDUCTIVE ELEMENT**
DRUCKSYSTEM MIT LEITFÄHIGEM ELEMENT
SYSTÈME D'IMPRESSION POURVU D'UN ÉLÉMENT CONDUCTEUR

(30) Priority: 26.12.2006 US 871868 P
(43) Date of publication of application: 16.09.2009
(73) Proprietor: Fujifilm Dimatix, Inc., Lebanon, NH 03766 (US)
(72) Inventor: GARDNER, Deane, A., Cupertino, California 95014-1403 (US); WEST, Daniel Alan, Los Gatos, California 95032 (US); HOISINGTON, Paul, A., Hanover, NH 03755 (US); BARSS, Steven, H., Wilmot Flat, New Hampshire 03287 (US); HIGGINSON, John, A., Santa Clara, California 95051 (US); BIBL, Andreas, Los Altos, California 94024 (US); OTTOSSON, Mats, Cupertino, California 95014 (US); YARP, Russ, Palo Alto, California 94301 (US)
(74) Representative: Peterreins, Frank
(86) International application number: PCT/US2007/088188
(87) International publication number: WO 2008/083002

(56) References cited:
- JP-A- 3 108 564
- JP-A- 57 043 879
- US-A1- 2004 201 648
- US-A1- 2004 246 309
- US-A1- 2006 187 264
- US-A1- 2006 244 778

## Description

### BACKGROUND

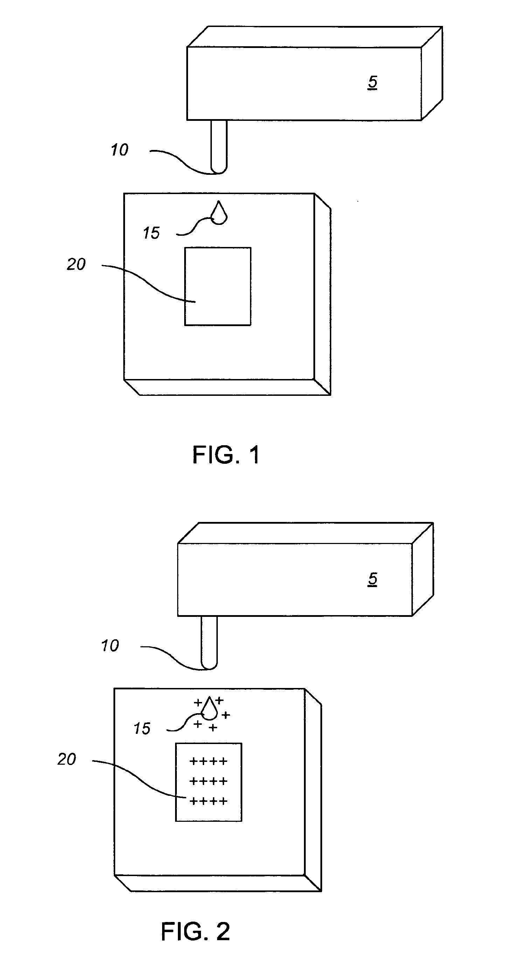

The following description relates to ink jet printing. Inkjet printing allows for precise deposition of material onto a substrate. Referring to FIG 1, in many inkjet systems, a printer 5 has a nozzle 10 with an associated actuating mechanism that expels a fluid droplet 15 onto a substrate 20. The nozzle 10 and substrate 20 are moved relative to one another to apply droplets 15 to different portions of the substrate 20. The printer can be controlled by associated software and hardware that instructs the printer to eject the droplet 15 when the nozzle 10 is at a predetermined relative position with respect to the substrate 20. Relative position between the substrate and nozzle, relative velocity, ink ejection velocity and vertical distance from substrate to nozzle determine the location of the droplet 15 on the substrate 20.
[0001.1] U.S. Patent Publication No. 2006/0187264 describes that aerosols can be applied to an absorbing member by forming a stable and uniform electric field between a nozzle plate and the absorbing member. A liquid ejecting apparatus includes: a liquid ejecting head that has a conductive nozzle plate and discharges liquid from openings of the nozzle plate during reciprocating above recording material; a recording material side electrode that is arranged farther than the recording material opposite the nozzle plate in a direction in which the liquid is discharged; a potential difference generating means that generates a potential difference between the nozzle plate and the recording material side electrode to electrically attract the liquid discharged from the openings of the nozzle plate toward the recording material side electrode; and a nozzle plate side electrode that is arranged in a direction of reciprocation of the nozzle plate and has a potential difference of the same direction as that of the potential difference between the nozzle plate and the recording material side electrode.
[0001.2] U.S. Patent Publication No. 2004/0246309 describes a table device for chucking a substrate that includes a chucking unit including a porous body, and having a substrate chucking surface, and a conductive film which is disposed on the substrate chucking surface of the chucking unit, and which is grounded.

### SUMMARY

A printing system is described that has a fluid emitter and a conductive plate. The fluid emitter is configured to emit droplets into a printing region on a substrate. The conductive plate is for supporting the substrate onto which the droplets are emitted, wherein the conductive plate is uniformly conductive within the printing region.

A system for printing onto a substrate is described. The system includes a printhead, a chuck for supporting a substrate on which the printhead is configured to deposit fluid and a conductive lead configured to be connected to a conductive portion of the substrate.

A method of printing onto a substrate is described. The method includes connecting a conductive portion of the substrate to ground, to a resistor or to a bias and printing onto the substrate.

The methods and systems described herein can include one or more of the following features. The conductive plate may be grounded or may be connected to a bias source. The conductive plate may have a uniform thickness within the printing region. The conductive plate may be free of recesses or holes within the printing region or be free from protruding features in the printing region. The conductive plate may be formed of metal, carbon loaded plastic, ElectroStatic Dissipative plastic or porous sintered metal. The conductive plate may be a conductive chuck that supports the substrate. A system may further comprise a chuck for supporting the substrate and the conductive plate is a conductive pad that is supported by the chuck or a vacuum apparatus in fluid communication with the conductive plate to hold the substrate fixedly in place. A system can include a conductive lead connected to a resistor. Printing the droplets can include printing onto an insulating substrate, an oxide or glass or plastic. Printing the droplets can include printing organic fluid, biological material or polymer, such as a polymer dissolved in a carrier vehicle. Printing onto a substrate can include forming a conductive layer on the substrate. Forming the conductive layer can include depositing a layer of carbon on the substrate or depositing a layer of metal on the substrate. The conductive portion of a substrate can be carbon, such as carbon black, or a layer of anti-static spray. The substrate may be a non-conductive porous substrate, such as a non-conductive porous plastic, rubber foam, adsorbent polyethylene fiber pad or ceramic. The printing system can include a drop watcher for recording drops that are formed and released from the printhead.

Potential advantages of the techniques described herein include being able to reduce the electrical voltage potential present on the surface of an insulating substrate. Charged droplets can be applied more accurately onto the substrate when the substrate's surface voltage, and hence the electrical field present between printhead nozzle and substrate surface is reduced. Smaller droplets, which are more easily deflected by an electric field, can be more accurately applied to an insulating substrate. When high precision printing onto an insulating substrate is required, such as in jetting biological fluids and forming high resolution displays using jetting to apply the display pixels, the conductive backing can allow for the accuracy in droplet deposition that is required. A dropwatcher on system can be used to set up printing of a new substance or fluid. Watching the formation of the droplets allows for modification to the waveform used to form the droplets and therefore can fine tune the printing process.

The details of one or more embodiments of the invention are set forth in the accompanying drawings and the description below. Other features, objects, and advantages of the invention will be apparent from the description and drawings, and from the claims.

### DESCRIPTION OF DRAWINGS

FIG. 1 is a schematic perspective view of a conventional printing system.

FIG. 2 is a schematic perspective view of a conventional printing system with an charge distribution built up on the substrate.

FIG 3 shows a schematic side view of a conventional printing system with an charge distribution built up on the substrate.

FIGS. 4-7 show schematics of printing systems configured to allow for accurate droplet placement.

FIG 8 shows a schematic of a printing system with a drop watcher.

Like reference symbols in the various drawings indicate like elements.

### DETAILED DESCRIPTION

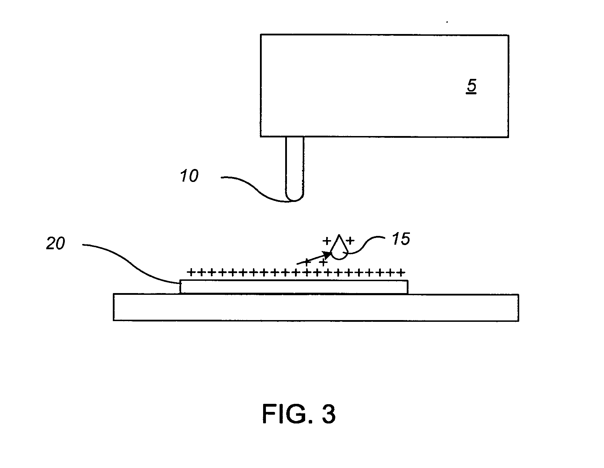

Referring to FIG. 2, as a droplet 15 is expelled from the nozzle 10, the droplet 15 often becomes charged. As charged droplets land on the substrate 20, a voltage field is produced around the deposited droplet on the substrate 20, if the substrate 20 is formed of an insulating material. If the substrate is made of conductive material but is not connected to an earth ground or to a related circuit ground potential, the entire substrate may develop a voltage potential through this mechanism. In addition, substrates may have accumulated a charge through handling or transport even prior to being printed upon. In some applications, the printing system is designed to use the charge on the droplet to control the direction of the droplet in flight. However in other applications, droplets ejected into a high voltage field undergo electrostatic deflection. This can affect the accuracy of the droplet deposition and hinder print precision and quality. The electric field deflects the charged droplet, forcing the droplet to move away from the desired deposition location on the substrate, as shown in FIG 3.

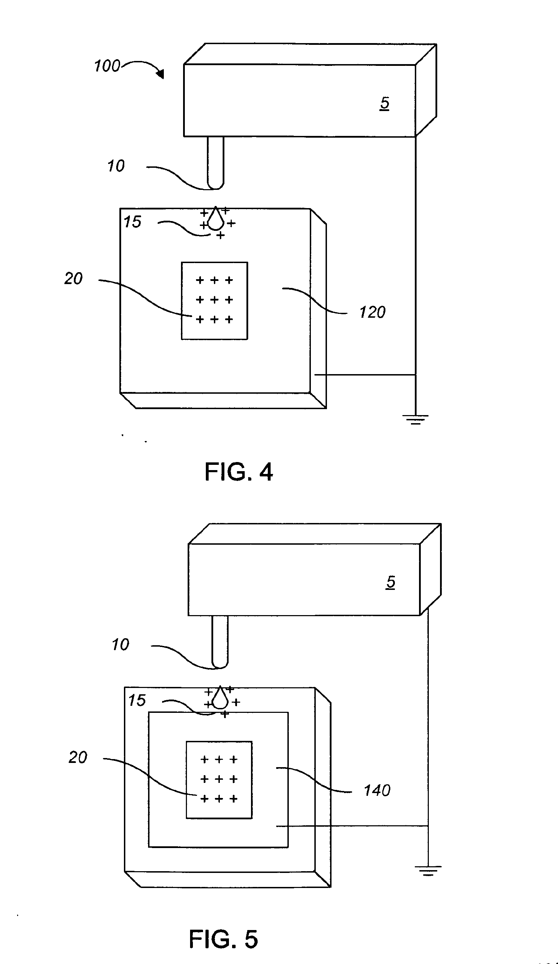

Referring to FIG. 4, a printing system 100, such as the printing system described in U.S. Publication No. 2007/0013736, filed 7/12/2006, entitled "Fluid Deposition Device", includes a printhead having one or more nozzles 10 to emit fluid. A chuck 120 or substrate support is provided beneath the nozzles 10. Drop placement is determined by the relative location of the nozzles 10 with a substrate on the chuck 120, thus, the nozzles 10 and/or the chuck 120 are moveable to allow for drop placement in a desired location. The chuck 120 is conductive. Whether the nozzles 10 or the chuck 120 move during printing, the chuck 120 is sized so that the nozzles arc over the chuck 120 when the nozzles 10 are emitting fluid onto a substrate 20.

The chuck 120 has uniform conductivity within the printing area. In some embodiments, the chuck 120 is as large as or has a perimeter that is greater than the perimeter of the substrate 20. If the chuck 120 extends at least to the edges of the substrate that is being printed on or beyond the edge of the substrate, areas of charge build-up are avoided on the substrate. In some embodiments, the chuck is free from areas of non-uniformity, such as holes, slots, recesses, raised features or changes in material, which can allow for regions of higher field strength to form on the substrate.

The chuck 120 is formed of a conductive material, such as a metal, carbon loaded plastic, electrostatic dissipative (ESD) plastic, that is, a plastic material with a resistivity in the range of 10⁹ Ohm*cm or less, or other suitable material. In some embodiments, the chuck is formed of a flat plate of porous sintered metal, which allows an integral substrate hold-down function through the use of an applied vacuum through the thickness of the metal. The chuck 120 is electrically connected to earth or circuit ground, either directly or through a component in the printing system 100, such as the circuitry that drives the printhead. To electrically ground the chuck, a conductive lead can be attached to the chuck, such as by direct contact, soldering or by forming a hole in the chuck and wrapping wire through the hole. The wire is then attached to ground. Alternatively, a fastener, such as a rivet or a screw is driven into the chuck and holds the wire in place on the chuck. In some embodiments, the chuck is slightly biased to a potential rather than being connected to ground. In some embodiments, the chuck is connected to a large-valued resistor. The chuck ground wire can be connected to the drive circuitry ground for the printer 5 or to a related earth ground.

Referring to FIG. 5, in an alternative embodiment, instead of a chuck, a conductive pad 140 is applied to the back of the substrate during printing. The pad need not be an integral part of the printing system 100 and therefore can be used to modify a system with either a non-conductive chuck or a chuck with non-uniform conductivity. The pad can simply be placed between the substrate and the chuck. The pad can be separately grounded or can be plugged into the printing system for grounding.

Whether a conductive pad or a conductive chuck is used, the substrate is in contact with the conductive material during printing. As the printing system 100 applies droplets onto the substrate, the substrate is moved relative to the nozzle. Even as the substrate moves, the chuck, or pad, is kept under the substrate in the printing area.

In some embodiments, a conductive layer is applied directly to the back side of the substrate, such as by sputtering or using a conductive paint or adhesive. The conductive layer is then grounded during printing. Optionally, the conductive layer can be removed once the printing process is complete.

Some types of substrates are particularly susceptible to charge buildup during printing. Porous substrates, for example, which are able to absorb the liquid components of the liquid printing fluid, formed of non-conductive materials can build up a charge. Porous plastic, such as plastic sheets available from Porex® in Fairburn, Georgia, and porous ceramics are substrates that can develop a net charge and repel drops jetted onto the substrate.

Solutions for printing onto porous substrates can include applying a conductive layer onto the porous substrate prior to printing. One exemplary method of printing onto a porous substrate includes depositing a layer of carbon onto the porous substrate to enhance conductivity of the substrate. In some substrates, carbon black is mixed into plastic prior to molding the plastic. The plastic can be any type of thermoplastic, such as polypropylene or polyethylene. Alternatively, or in addition, a conductive layer is applied to the porous substrate, such as by sputtering a layer of metal onto the substrate. The conductive layer can be removed after printing, if desired. Another method of printing onto a porous substrate includes selecting a conductive porous substrate, such as a sintered carbon or sintered nickel substrate, for example, parts made from stainless steel, bronze, nickel, nickel based alloys, titanium, copper, aluminum or precious metals, such as porous metal parts available from Mott Corporation, Farminton, CT. As with the conductive backing, the conductive material is connected to a ground or is slightly biased to drain off charge. Yet another solution is to apply an anti-static spray, such as StatFree Spray, available from PerfectData® in Norristown, PA, to the substrate to dissipate charge. The spray forms a layer of slightly conductive anti-static material on the substrate. Alternatively, if the ink is conductive, the ink can be used to provide a path to a ground connection.

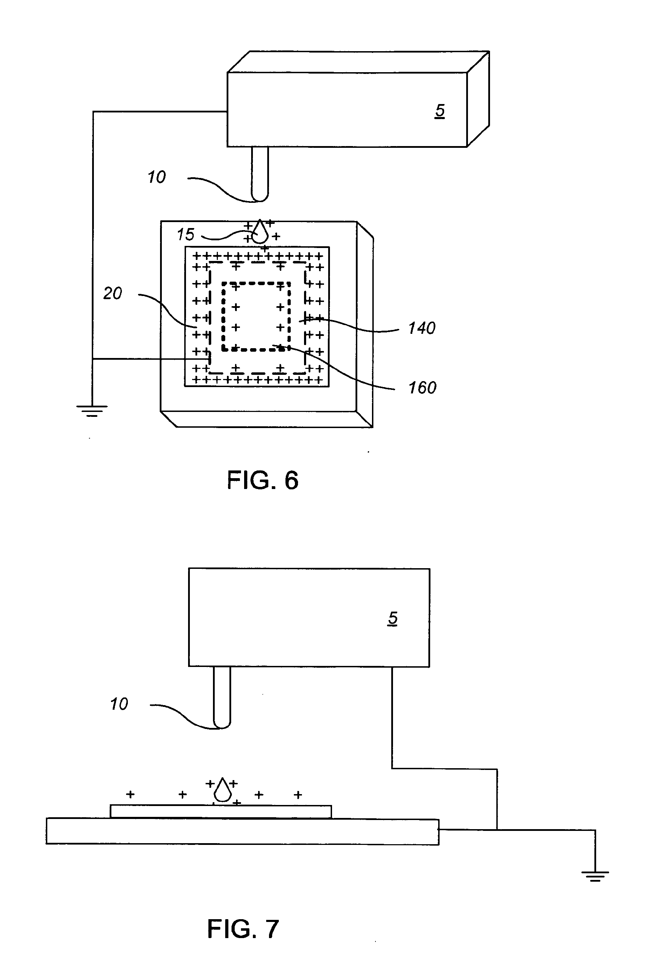

Referring to FIG. 6, the conductive pad 140 (shown in phantom) need not be as large as the substrate 20. The conductive pad 140 is, however, as large as or larger than the printing area 160 (shown in phantom) on the substrate. The area of the substrate 20 that is within the printing area has a substantially reduced electrical field on its surface in comparison to the areas of the substrate 20 that do not correspond to the location of the conductive pad 140.

While the conductive layer, chuck or pad, conductive backing for short, is able to reduce the electrical field that is formed on the substrate, it may not entirely eliminate the electric field. The conductive backing effectively increases the capacitance presented to the charge on the surface of the substrate. The magnitude of the charge formed upon ejection of the fluid droplets is more or less constant regardless of the presence of the conductive backing. Thus, the same amount of charge is delivered to the substrate during printing, and accumulated on its surface, with or without the conductive backing in place. Thus, by increasing the capacitance presented to the charge the electric field between the substrate and the printhead nozzle is also greatly reduced, compared to when there is no conductive backing. The difference between printing on an insulating substrate with and without a conductive backing can be a factor between 2 - 1000 or more. The effect of reducing the electric field on the surface of the substrate is that when a charged droplet approaches the surface of the substrate, the reduced electric field creates proportionately less deflection of the charged droplet than would a higher electric field. The droplet is able to land in the desired position without being significantly affected by the deposited surface charge, as shown in FIG. 7.

To enable using any of the conductive backings, layers or substrates described herein, a printing system can optionally include a conductive lead that can be connected to the conductive element. The lead is electrically conductive and connected to either ground, a relatively large resistor, that is, a resistor with a resistance greater than a mega-ohm, or a voltage source, such as a small DC or AC voltage source. The lead can include a wire, a conductive adhesive, a fastener, such as an alligator clip, or other element that enables the lead to be fastened, either temporarily or permanently, to the conductive element.

A printing system with the conductive plate or conductive chuck described herein is capable of reducing electric field build up on an insulating substrate, even in low humidity or low oxygen environments. This can be advantageous when the droplets or the substrate must be kept in an environment that is free from water or oxygen. Such droplets can be water or oxygen sensitive organic materials, such as electrically conductive polymers, biological materials, desiccating materials, DNA precursors or other such sensitive materials. Accurate droplet placement can be more critical in applications where very small droplets are required, such as to form high resolution displays or to test biological samples where only a very minute amount of sample is applied. As drops get smaller, the absolute amount of charge per drop generated is larger, so the critical quantity, that is, the charge to mass ratio, is much larger. Smaller droplets in the range of 0.1 to 20 picoliters are more prone to being forced away from a desired printing location by an electric field on a substrate than larger droplets. Larger droplets are often better able to resist the force from the electric field because of their greater droplet mass relative to the droplet's ejection-induced charge potential, and are less likely to stray from their trajectory.

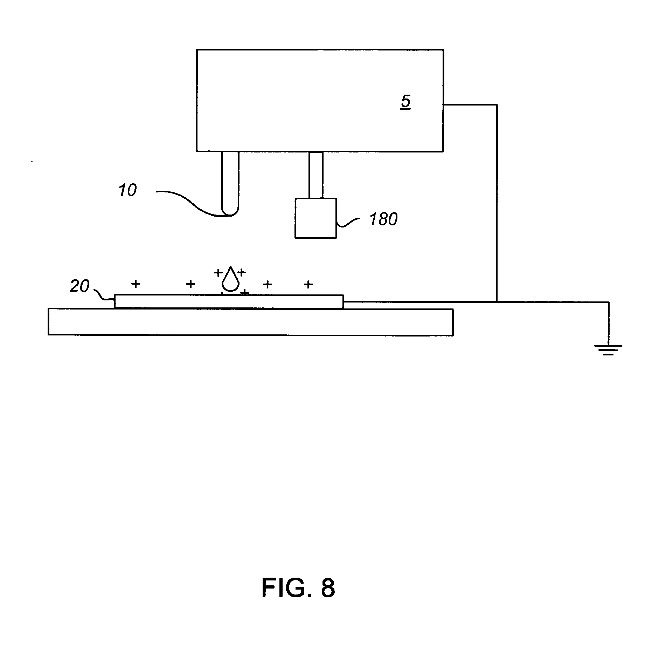

The conductive backing can be useful in a number of applications, such as printing liquid crystal color filter material onto glass to form LCD display components, forming plasma displays or backplanes, or printing biological samples or DNA precursors onto a glass substrate or slide. Printing into or onto a grounded conductive porous substrate or a porous substrate having a grounded conductive layer thereon can be useful when multiple droplets are being jetted at the same location. The systems and techniques described herein can also be used to set up a printer for printing a new material. For example, in a system having a drop watcher 180, as described in U.S. Publication No. 2007/0013736, droplets can be repeatedly printed onto a substrate 20 to determine the shape of the droplet and to optimize the waveform used to jet the droplets, as shown in FIG. 8. The droplets can be printed onto a porous substrate 20 to prevent splashing of the droplets onto the drop watcher 180 camera or build-up of jetted fluid. If the porous substrate 20 is insulative and lacks a conductive layer, as described herein, charge can build up on the substrate and misdirect subsequently jetted droplets. A grounded conductive porous substrate allows for repeatable droplet placement in this situation. Using a grounded conductive substrate, whether porous or non-porous, with a drop watcher allows for drops to be printed onto the substrate with a camera recording the drop formation, release and fall without electrostatic interference altering the drop's behavior. The drop behavior that is recorded by the camera can be used to fine tune the waveform used to form the droplet.

A number of embodiments of the invention have been described. Nevertheless, it will be understood that various modifications may be made without departing from the scope of the invention as claimed. Accordingly, other embodiments are within the scope of the following claims.

## Claims

1. An ink jet printing system (100) comprising:
a fluid emitter configured to emit droplets into a printing region on a substrate (20) onto which the droplets are emitted;
the substrate having either
a conductive pad acting as a conductive plate for supporting the substrate, placeable between the substrate and a chuck (120) to be supported by the chuck (120), and uniformly conductive within the printing region or
a conductive layer applied to the back side of the substrate,
the conductive pad or conductive layer connected to ground, to a resistor, or to a bias; and
the chuck (120) for supporting the substrate (20).

2. The system of one of the preceding claims, wherein the conductive plate has a uniform thickness within the printing region.

3. The system of one of the preceding claims, wherein the conductive plate is free of recesses, holes or protruding features within the printing region.

4. The system of one of the preceding claims, wherein the conductive plate is formed of metal or carbon loaded plastic.

5. The system of one of the preceding claims, wherein the substrate has a removable conductive layer applied to the back side thereof.

6. The system of one of the preceding claims, wherein the substrate has a sputtered conductive layer applied to the back side thereof.

7. The system of one of the preceding claims, wherein the substrate is a porous substrate having a layer of carbon deposited thereon.

8. The system of one of the preceding claims, wherein the substrate is a porous substrate having a layer of slightly conductive antistatic spray material thereon.

9. The system of one of claims 1 to 4, wherein the substrate has the conductive pad and the chuck is non-conductive.

10. The system of one of claims 1 to 4, wherein the substrate has the conductive pad and the chuck has non-uniform conductivity.

11. The system of one of claims 1 to 4, wherein the substrate has the conductive pad and the conductive pad is smaller than the substrate.

12. A method of printing droplets, comprising printing fluid droplets using the ink jet printing system of claim 1.

13. The method of claim 12, further comprising printing onto the substrate, comprising:
connecting a conductive portion of the substrate to the ground, to the resistor or to the bias; and
printing onto the substrate using the fluid emitter configured to emit the droplets into the printing region on the substrate.

14. The method of claim 13, further comprising forming the conductive layer on the substrate, for example, by depositing a layer of carbon on the substrate or by depositing a layer of metal on the substrate.

15. The method of claim 13, wherein the substrate is a porous substrate, for example, a non-conductive porous substrate.

16. The method of claim 13, wherein printing includes forming a drop and releasing the drop from a printhead, the method further comprising recording the forming and releasing with a camera.

## Patentansprüche

1. Tintenstrahl-Drucksystem (100) umfassend:
einen Fluid-Emitter, ausgelegt, um Tröpfchen in einen Druckbereich auf einem Substrat (20) auszustoßen, auf das die Tröpfchen ausgestoßen werden;
das Substrat hat entweder
ein leitfähiges Pad, das als eine leitfähige Platte funktioniert, um das Substrat abzustützen, platzierbar zwischen dem Substrat und einem Futter (120), um von dem Futter (120) abgestützt zu werden, und gleichmäßig leitfähig innerhalb des Druckbereichs, oder
eine leitfähige Schicht, aufgebracht auf der Rückseite des Substrats, wobei das leitfähige Pad oder die leifähige Schicht mit Erde, einem Widerstand oder einer Vorspannung verbunden ist; und
wobei das Futter (120) zum Abstützen des Substrats (20) ist.

2. Das System nach einem der vorangehenden Ansprüche, wobei die leitfähige Platte eine gleichmäßige Dicke innerhalb des Druckbereichs hat.

3. Das System nach einem der vorangehenden Ansprüche, wobei die leitfähige Platte frei von Aussparungen, Löchern oder hervorstehenden Merkmalen innerhalb des Druckbereichs ist.

4. Das System nach einem der vorangehenden Ansprüche, wobei die leitfähige Platte aus Metall oder Kohlenstoff beladenem Plastik gebildet ist.

5. Das System nach einem der vorangehenden Ansprüche, wobei das Substrat eine abnehmbare, leitfähige Schicht hat, die auf der Rückseite davon aufgebracht ist.

6. Das System nach einem der vorangehenden Ansprüche, wobei das Substrat eine gespritzte, leitfähige Schicht hat, die auf der Rückseite davon aufgebracht ist.

7. Das System nach einem der vorangehenden Ansprüche, wobei das Substrat ein poröses Substrat ist, mit einer Schicht aus Kohlenstoff drauf abgelegt.

8. Das System nach einem der vorangehenden Ansprüche, wobei das Substrat ein poröses Substrat ist, mit einer Schicht aus leicht leitfähigem antistatischem Spritzmaterial.

9. Das System nach einem der Ansprüche 1 bis 4, wobei das Substrat das leitfähige Pad hat und das Futter nicht leitfähig ist.

10. Das System nach einem der Ansprüche 1 bis 4, wobei das Substrat das leitfähige Pad hat und das Futter eine ungleichmäßige Leitfähigkeit hat.

11. Das System nach einem der Ansprüche 1 bis 4, wobei das Substrat das leitfähige Pad hat und das leitfähige Pad kleiner als das Substrat ist.

12. Verfahren zum Drucken von Tröpfchen umfassend das Drucken von Fluid-Tröpfchen unter Verwendung des Tintenstrahl-Drucksystems nach Anspruch 1.

13. Das Verfahren nach Anspruch 12, weiter umfassend Drucken auf das Substrat, umfassend:
Verbinden eines leitfähigen Teils des Substrats mit Erde, dem Widerstand oder der Vorspannung; und
Drucken auf das Substrat unter Verwendung des Fluid-Emitters,
der ausgelegt ist, um Tröpfchen in den Druckbereich auf dem Substrat auszustoßen.

14. Das Verfahren nach Anspruch 13, weiter umfassend Formen der leitfähigen Schicht auf dem Substrat, zum Beispiel, durch Ablegen einer Schicht aus Kohlenstoff auf dem Substrat oder durch Ablegen einer Schicht aus Metall auf dem Substrat.

15. Das Verfahren nach Anspruch 13, wobei das Substrat ein poröses Substrat ist, zum Beispiel, ein nicht leitfähiges poröses Substrat.

16. Das Verfahren nach Anspruch 13, wobei Drucken Bilden eines Tropfens und Ausgeben des Tropfens von einem Druckkopf beinhaltet, wobei das Verfahren weiter Aufnehmen des Bildens und Ausgebens mit einer Kamera umfasst.

## Revendications

1. Système d'impression à jet d'encre (100), comprenant:
un émetteur de fluide configuré de manière à émettre des gouttelettes dans une région d'impression sur un substrat (20) sur lequel les gouttelettes sont émises;
le substrat présentant
soit un tampon conducteur qui agit comme une plaque conductrice pour supporter le substrat, qui peut être placé entre le substrat et un mandrin (120) pour être supporté par le mandrin (120), et qui est uniformément conducteur à l'intérieur de la région d'impression,
soit une couche conductrice qui est appliquée sur la face arrière du substrat,
le tampon conducteur ou la couche conductrice étant connecté(e) à la terre,
à une résistance ou à un élément de polarisation; et
le mandrin (120) pour supporter le substrat (20).

2. Système selon l'une quelconque des revendications précédentes, dans lequel la plaque conductrice présente une épaisseur uniforme à l'intérieur de la région d'impression.

3. Système selon l'une quelconque des revendications précédentes, dans lequel la plaque conductrice est exempte d'évidements, de trous ou de caractéristiques saillantes à l'intérieur de la région d'impression.

4. Système selon l'une quelconque des revendications précédentes, dans lequel la plaque conductrice est constituée de plastique chargé de carbone ou de métal.

5. Système selon l'une quelconque des revendications précédentes, dans lequel le substrat présente une couche conductrice amovible qui est appliquée sur la face arrière de celui-ci.

6. Système selon l'une quelconque des revendications précédentes, dans lequel le substrat présente une couche conductrice pulvérisée qui est appliquée sur la face arrière de celui-ci.

7. Système selon l'une quelconque des revendications précédentes, dans lequel le substrat est un substrat poreux qui présente une couche de carbone déposée sur celui-ci.

8. Système selon l'une quelconque des revendications précédentes, dans lequel le substrat est un substrat poreux qui présente une couche d'une matière de projection antistatique légèrement conductrice sur celui-ci.

9. Système selon l'une quelconque des revendications 1 à 4, dans lequel le substrat comprend le tampon conducteur et le mandrin est non conducteur.

10. Système selon l'une quelconque des revendications 1 à 4, dans lequel le substrat comprend le tampon conducteur et le mandrin présente une conductivité non uniforme.

11. Système selon l'une quelconque des revendications 1 à 4, dans lequel le substrat comprend le tampon conducteur, et le tampon conducteur est plus petit que le substrat.

12. Procédé d'impression de gouttelettes, comprenant l'impression de gouttelettes de fluide en utilisant le système d'impression à jet d'encre selon la revendication 1.

13. Procédé selon la revendication 12, comprenant en outre l'impression sur le substrat, comprenant les étapes suivantes:
connecter une partie conductrice du substrat à la terre, à la résistance ou à l'élément de polarisation; et
imprimer sur le substrat en utilisant l'émetteur de fluide qui est configuré de manière à émettre les gouttelettes dans la région d'impression sur le substrat.

14. Procédé selon la revendication 13, comprenant en outre la formation de la couche conductrice sur le substrat, par exemple en déposant une couche de carbone sur le substrat ou en déposant une couche de métal sur le substrat.

15. Procédé selon la revendication 13, dans lequel le substrat est un substrat poreux, par exemple, un substrat poreux non conducteur.

16. Procédé selon la revendication 13, dans lequel l'impression comprend la formation d'une goutte et la libération de la goutte à partir d'une tête d'impression, le procédé comprenant en outre l'enregistrement de la formation et de la libération à l'aide d'une caméra.
